# EUROPEAN PATENT SPECIFICATION

(11) **EP 1 672 093 B1**
(45) Date of publication and mention of the grant of the patent: **10.07.2013**
(21) Application number: 04773039.5
(22) Date of filing: 14.09.2004
(51) Int. Cl.: C23C 16/455, H01L 21/31

(54) **FILM-FORMING APPARATUS AND FILM-FORMING METHOD**
FILMBILDUNGSVORRICHTUNG UND FILMBILDUNGSVERFAHREN
APPAREIL ET PROCEDE DE FORMATION DE FILMS

(30) Priority: 17.09.2003 JP 2003325004
(43) Date of publication of application: 21.06.2006
(73) Proprietor: TOKYO ELECTRON LIMITED, Tokyo 107-8481 (JP); SAMUKAWA, Seiji, Sendai-shi, Miyagi 9893212 (JP)
(72) Inventor: SAMUKAWA, Seiji, Sendai-shi, Miyagi 989-3212 (JP); NOZAWA, Toshihisa c/o Tokyo Electron AT Limited, Amagasaki City Hyogo 660-0891 (JP)
(74) Representative: HOFFMANN EITLE
(86) International application number: PCT/JP2004/013357
(87) International publication number: WO 2005/028703

(56) References cited:
- EP-A- 1 300 875
- EP-A- 1 300 878
- JP-A- 06 236 850
- JP-A- 06 260 434
- JP-A- 2000 144 421
- JP-A- 2000 345 349
- JP-A- 2002 016 056
- US-A- 4 563 367
- US-A- 6 162 323
- US-A1- 2001 042 512
- US-A1- 2002 006 478
- US-A1- 2002 068 458
- US-A1- 2003 118 748

## Description

### TECHNICAL FIELD

The present invention relates to a deposition apparatus and more particularly, it relates to a deposition apparatus in which a film can be formed in a short time.

### BACKGROUND ART

A deposition apparatus and a deposition method using CVD are disclosed in Japanese Unexamined Patent Publication No. 2001-185546 and in Japanese National Publication of International Application No. 2002-539326.

The Japanese Unexamined Patent Publication No. 2001-185546 discloses a deposition apparatus having a reaction chamber in which a substrate is set and a plasma generation chamber which is separated by electrodes from the reaction chamber in a vacuum container to be evacuated to a vacuum and a film is formed in the reaction chamber. A structure of the electrode part is in the shape of a mesh or a comb. Thus, plasma formed in the plasma generation chamber is confined and a radical can be transmitted. By carrying the radical formed in the plasma generation chamber into the reaction chamber and introducing a second gas into the reaction chamber, a vapor phase reaction with the radical or a surface reaction on the substrate proceeds and the film is formed on the substrate.

The Japanese Unexamined Patent Publication No. 2002-539326 discloses a method of depositing metal on a substrate surface in a deposition chamber. The method comprising (a) a step of depositing a monolayer of metal on the substrate surface by applying a metal molecular precursor gas or vapor including metal onto the substrate surface, so that the surface is saturated by a first reactive species with which the precursor will react by depositing the metal and forming a reaction product, leaving a metal surface covered with ligands from the metal precursor whereby further reaction with the precursor will not occur, (b) a step of terminating flow of the precursor gas or vapor; (c) a step of purging the precursor with an inert gas; (d) a step of providing a first reactive species by supplying at least one radical species having high reactive characteristics with the surface ligands on the metal precursor layer to the substrate surface in the chamber and removing the ligands as the reaction product and saturating the surface; (e) a step of repeating the above steps in order until a metal film having a desired thickness is provided.

The conventional deposition apparatus and the deposition method using CVD are as described above. According to the Japanese Unexamined Patent Publication No. 2001-185546, there is a problem as described below. More specifically, since the reaction chamber for setting the substrate and the plasma generation chamber are separated by the electrode only, the deposition gas flows into the plasma generation chamber and the deposition gas reacts with the radical, so that the film is formed in the plasma generation chamber also.

According to the Japanese Unexamined Patent Publication No. 2002-539326, the monolayer of the metal is formed by applying the metal molecular precursor gas or the vapor containing metal on the substrate surface and after the surface is saturated with the first reactive species with which the precursor reacts by depositing the metal and forming the reactive product, the flow of the precursor gas or the vapor is terminated, and the precursor is purged with the inert gas, and the ligands are removed by suplying the radical species to the substrate surface. Thus, since the purging process is indispensable in the deposition process, it takes time to form the film.

US 2002/0006478 A1 discloses a method of forming a silicon oxide film by the use of plasma CVD apparatus, and a forming apparatus of silicon oxide film. The plasma CVD apparatus includes a plasma generation region for forming plasma of a gas containing oxygen atoms, a substrate holding mechanism for arranging the substrate outside the plasma generation region, and means for supplying gas containing silicon atoms between the plasma generation region and the substrate.

US 2001/0042512 A1 discloses a CVD apparatus which produces plasma to generate radicals and uses the radicals, together with silane and the like, to deposit films on substrates in a vacuum vessel. The vacuum vessel has a partitioning wall section for separating the inside thereof into a plasma-generating space and a film deposition process space. The partitioning wall section has a plurality of through-holes and diffusion holes. An interior space receives the silane or the like fed into the film deposition process space through diffusion holes. The radicals produced in the plasma-generating space are fed into the film deposition process space through the through-holes.

US 2002/0068458 A1 discloses a system and sequential method for integrated, in-situ modification of a substrate and subsequent atomic layer deposition of a thin film onto the substrate in an evacuated chamber.

### SUMMARY OF THE INVENTION

An advantage obtainable with embodiments of the present invention is to provide a deposition apparatus in which a film is not adhered to a plasma generation chamber and a film can be formed in a short time. A deposition method suitable for use with embodiments of the present invention is also described.

According to the present invention, there is provided a deposition apparatus as recited in claim 1 below.

Thus, the plasma generation chamber and the deposition chamber are separated by the distribution plate and the plurality of holes are formed in the distribution plate so that the pressure of the plasma generation chamber may become the positive pressure as compared with the pressure of the deposition chamber and a diameter of said through holes in the distribution plate is large on an upper surface and small on a lower surface. Therefore, the deposition gas will not flow into the plasma generation chamber. As a result, the film is not formed in the plasma generation chamber. In addition, since a radical can be continuously supplied to the deposition chamber, the substrate is not saturated with the deposition gas as in the conventional case. Since the purging process which is performed in the conventional method is not needed, the deposition time can be reduced.

Preferably, the deposition apparatus comprises means for applying a predetermined bias voltage between the plasma generation chamber and the deposition chamber.

Since the predetermined bias voltage is applied between the plasma generation chamber and the deposition chamber, ions generated in the plasma generation chamber based on the treatment gas are selectively introduced into the deposition chamber according to a polarity of the bias voltage.

More preferably, a diameter of the hole is so constituted that a pressure difference between the plasma generation chamber and the deposition chamber becomes 1.5 times or more.

Still more preferably, the diameter of the hole is so constituted that a pressure difference between the plasma generation chamber and the deposition chamber becomes 2.0 times or more. When the pressure difference becomes 2.0 times or more, the gas passes through the hoe at sonic speed.

As a result, the deposition gas does not flow into the plasma generation chamber.

As deposition gas supplying means for supplying the deposition gas is provided in the deposition chamber to form the desired film on the substrate, and the deposition gas supplying means has spouts which are distributed over almost an entire region of the deposition chamber, the deposition gas supplying means may be constituted integrally with the distribution plate.

The distribution plate is preferably formed of carbon, silicon or aluminum.

In addition, plasma is preferably generated using a microwave or a inductive coupled plasma method.

When putting into effect embodiments of the present invention, a desired film may be deposited on a substrate by confining a deposition gas in a deposition region of the substrate, and by continuously polymerizing a deposition component contained in the deposition gas on the substrate through a radical thereby to form a desired film on the substrate.

Since the deposition gas is confined in the deposition region of the substrate and the deposition component in the deposition gas is polymerized on the substrate through the radical, the purging process is not necessary as is needed in the conventional case. As a result, there is able to be provided a deposition method in which the film can be formed in a short time.

According to such a deposition method, when a metal film is formed, a hydrogen radical is used, and when an oxide film is formed, an oxygen radical is used, and when a nitride film is formed, a nitrogen radical is used.

Preferably, the step of continuously polymerizing the deposition component through the radical comprises a step of continuously generating the radical and a step of supplying the deposition gas to the deposition region according to the desired film, the step of continuously generating the radical is performed at a first pressure, the step of supplying the deposition gas to the deposition region according to the desired film is performed at a second pressure, and the first pressure is at least 1.5 times as high as the second pressure.

More preferably, such a deposition method comprises a step of neutralizing the radical, and the step of continuously polymerizing the radical comprises a step of supplying a neutralized radical to the substrate.

### BRIEF DESCRIPTION OF DRAWINGS

To better explain the present invention, and to show how the same may be carried into effect, reference will be made, by way of example only, to the accompanying drawings, in which:
Fig. 1 is a schematic sectional view showing a deposition apparatus according to one embodiment of the present invention;
Fig. 2A not according to the invention is a view showing a distribution plate; Fig. 2B not according to the invention is a cross sectional view showing the distribution plate;
Fig. 3 not according to the invention is a view showing a state in which a gas passes through a hole of the distribution plate;
Fig. 4 is a view showing one example of the hole of the distribution plate according to embodiments of the present invention;
Fig. 5A is a view showing a step of a conventional deposition method;
Fig. 5B is a view showing a step of the conventional deposition method;
Fig. 5C is a view showing a step of the conventional deposition method;
Fig. 5D is a view showing a step of the conventional deposition method;
Fig. 6A is a view showing a step of a deposition method usable in conjunction with one embodiment of the present invention;
Fig. 6B is a view showing a step of the deposition method usable in conjunction with one embodiment of the present invention; and
Fig. 6C is a view showing a step of the deposition method usable in conjunction with one embodiment of the present invention.
Fig. 7 is a schematic sectional view showing a deposition apparatus according to another embodiment of the present invention.

### DETAILED DESCRIPTION

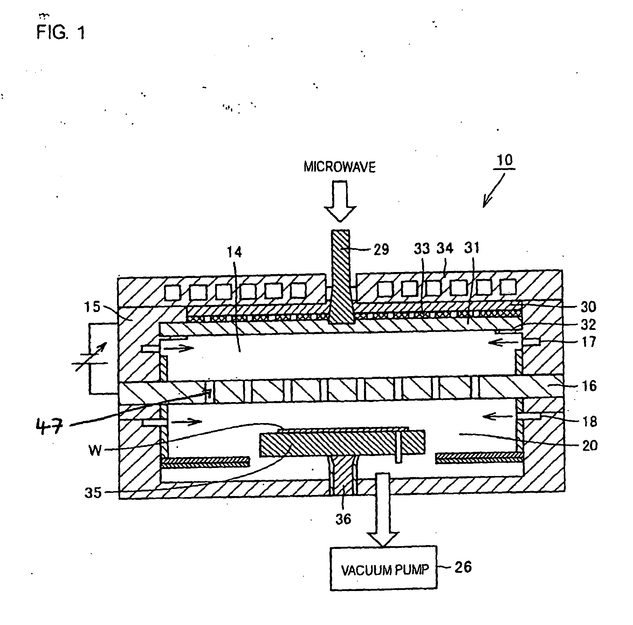

An embodiment of the present invention will be described with reference to the drawings hereinafter. Fig. 1 is a schematic sectional view showing a constitution of a deposition apparatus 10 according to one embodiment of the present invention. Referring to Fig. 1, the deposition apparatus 10 comprises a plasma processing apparatus. The deposition apparatus 10 has a cylindrical treatment container 15 whose side wall and bottom are formed of a conductor such as aluminum.

A plasma generation chamber 14 and a deposition chamber 20 in which a film is formed on a substrate with a deposition gas are provided in the treatment container 15 and they are separated by a distribution plate 16. Many holes having fine diameters are formed in the distribution plate 16. This will be described in detail below.

A ceiling of the treatment container 15 is open and a dielectric plate 31 formed of a ceramic material such as AlN, Al2O3, SiO2 and having a thickness of about 20mm which penetrates a microwave is provided here through a sealing member such as an O ring in a state it is supported by a support member 32.

A slot plate 33 functioning as a disk-shaped planar antenna is provided on the dielectric plate 31. A cooling plate 34 in which a cooling material flows is provided on the slot plate 33 through a dielectric plate 30.

The dielectric plate 30 is formed of quart, alumina, aluminum nitride and the like. The dielectric plate 30 is called as a slow wave-plate or a wavelength-shortening plate in some cases, which lowers a propagation speed of a microwave and shortens a wavelength thereof to improve propagation efficiency of the microwave emitted from the slot plate 33.

An upper center of the treatment container 15 is connected to a coaxial waveguide 29. The coaxial waveguide 29 is connected to a microwave generator (not shown) and it propagates the microwave to the slot plate 33. As this waveguide 29, a waveguide having a circular section or rectangular section or the coaxial waveguide can be used.

The deposition chamber 20 houses a pedestal 35 on which an object to be processed such as a semiconductor substrate W is set. The pedestal 35 is made of alumite-treated aluminum into cylindrical or square shape. A support column 36 which is made of aluminum into the column shaped also is provided under this pedestal 35 to support it. The support column 36 is set in the bottom of the treatment container 15 through an insulating material. An electrostatic chuck or a clamp mechanism (not shown) to hold the semiconductor substrate W is provided on an upper surface of the pedestal 35 in some cases.

A jacket (not shown) to circulate cool or warm water is provided on the support column 36 which supports the pedestal 35 to control a temperature of the substrate at the time of the plasma processing. Since a temperature of the pedestal 35 is controlled so as to be lower than that of a wall surface of the treatment container 15, the deposition gas or the like will not adhere on the wall surface of the treatment container 15.

A treatment gas supply nozzle 17 to introduce a predetermined treatment gas to the plasma generation chamber 14 is provided at a predetermined position of a side surface of the plasma generation chamber 14 in the treatment container 15. The treatment gas comprises an inert gas. As the inert gas, argon Ar is used and the treatment gas depends on a kind of the film to be formed such that H₂+Ar gas, O₂+Ar gas, N₂+Ar gas are used when the film is a metal film, an oxide film, a nitride film, respectively. The treatment gas supply nozzle comprises a quartz pipe, an aluminum structure and the like.

A deposition gas supply nozzle 18 to introduce the deposition gas to be deposited on the substrate is provided in the side surface of the deposition chamber 20 in the treatment container 15. The deposition gas supply nozzle 18 comprises a quartz pipe, an aluminum structure and the like.

In addition, the deposition gas supply nozzle 18 may be formed in the distribution plate 16.

As the deposition gas, silicon tetrachloride, tungsten hexafluoride, tantalum pentachloride, trimethyl aluminum, aluminum trichloride, titanium tetrachloride, titanium tetraiodide, molybudenum hexafluoride, zinc dichloride, hafnium tetrachloride, niobium pentachloride, copper chloride and the like are used.

In addition, a gate valve (not shown) to be opened or closed when the substrate is carried in or out of the treatment container 15 is provided in the side wall of the treatment container 15 and a jacket to control a temperature of this side wall is also provided there. In addition, an exhaust outlet connected to a vacuum pump (evacuating means) 26 is provided in the bottom of the treatment container 15, so that the treatment container 15 can be evacuated to a predetermined pressure according to need.

In addition, a variable DC bias voltage or a predetermine bias voltage is applied between the distribution plate 16 and the plasma generation chamber. This bias voltage is set at 10eV to 50eV or more according to a treatment condition.

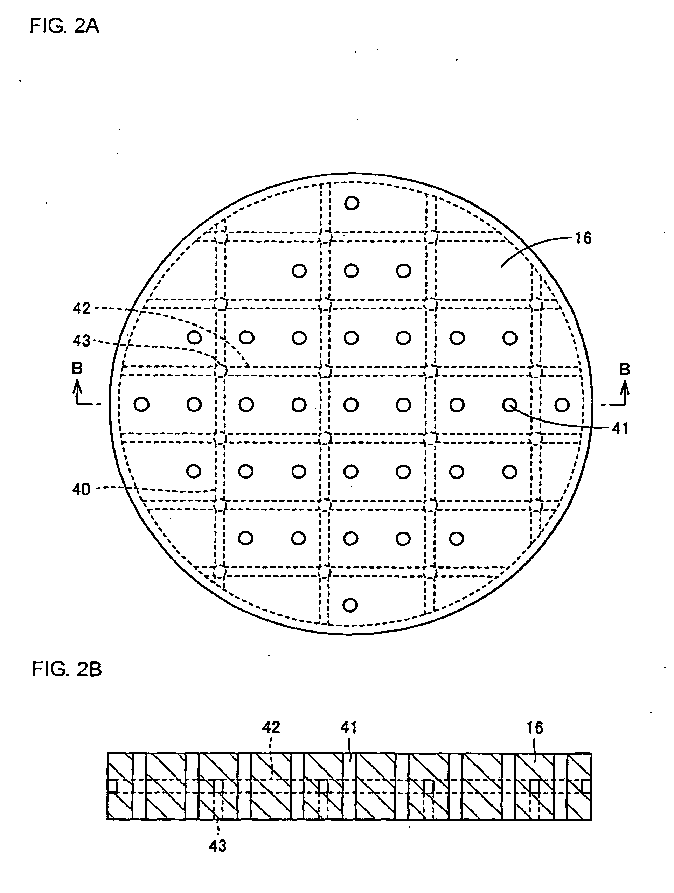

Next, the distribution plate 16 will be described with reference to Figs. 2A and 2B. Fig. 2A is a plan view showing the distribution plate 16, and Fig. 2B is a sectional view taken along line B-B in Fig. 2A.

As described above, the holes are formed in the distribution plate 16 provided between the plasma generation chamber 14 and the deposition chamber 20 so that a pressure in the plasma generation chamber 14 becomes positive as compared with the pressure in the deposition chamber 20 by a predetermined pressure difference. That is, a diameter of the hole is selected so that at least 1.5-fold pressure difference may be generated, and preferably 2-fold pressure difference or more may be generated between both chambers. More specifically, although it is preferable that a hole diameter is 1mm and a hole depth is 5mm or more, it depends on a treatment gas flow rate.

Referring to Figs. 2A and 2B, the distribution plate 16 illustrated incorporates a deposition gas passage 40 which supplies the deposition gas. The deposition gas passage 40 is connected to the deposition gas supply nozzle 18 (refer to Fig. 1) provided at the predetermined position of a periphery of the treatment container 15 and supplies the deposition gas to the deposition chamber 20.

The distribution plate 16 is in the shape of a disk and comprises the many small holes 41, gas passages 42 aligned like an array around the holes 41 and spouts 43 provided at intersections of the gas passage 42. The gas passage 42 and the spout 43 are not limited to the illustrated ones and the gas passage 42 may be connected to a wall surface of the hole 41 so that the deposition gas can be discharged to the hole 41. In embodiments of the invention, the through holes have large diameter on the upper surface and small diameter on the lower surface.

In order to attain at least 1.5-fold pressure difference between the plasma generation chamber 14 and the deposition chamber 20, both chambers are to be isolated by the distribution plate 16 and the diameter of the hole 41 provided in the distribution plate 16 is to be appropriately selected. When 2-fold pressure difference is implemented between both chambers, the gas passes through the hole 41 at sonic speed. Thus, the deposition gas in the deposition chamber 20 never flows into the plasma generation chamber 14. As a result, the deposition will not occur caused by the deposition gas in the plasma generation chamber 14. The gas flow rate is not necessarily the sonic speed and the same effect can be provided when the gas flow rate is close to it. Therefore, as described above, the pressure of the plasma generation chamber 13 may be 1.5 times as high as that of the deposition chamber 20.

According to a specific example of the pressures of those chambers, the pressure of the plasma generation chamber 14 is 20mTorr 1m Torr = 0.133 Pa to 500mTorr and the pressure of the deposition chamber is 10mTorr to 50mTorr.

Furthermore, according to distribution of the holes 41 in the distribution plate 16, the holes 41 are to be more densely distributed in the periphery by about 10% than those in the center of the distribution plate 16. For example, while the holes are provided at a pitch of 10mm in the center, the holes are provided at a pitch of 9mm in the periphery. This is because a plasma density is high in the center and low in the periphery.

In addition, as a material of the isolating plate 16, although carbon is preferable, aluminum or silicon may be used.

Next, a description will be made of a case a DC or AC bias voltage is applied between the distribution plate 16 and the side surface of the treatment container 15 of the plasma generation chamber 14. When the bias voltage is applied between the distribution plate 16 and the plasma generation chamber 14, a radical and /or an inert gas having a desired polarity of radicals generated in the plasma generation chamber 14 and a charged inert gas can be selectively taken out through the hole or neutralized. For example, positively charged argon Ar⁺ or hydrogen H⁺ radical can be drawn into the deposition chamber 20 or neutralized to cause a desired reaction.

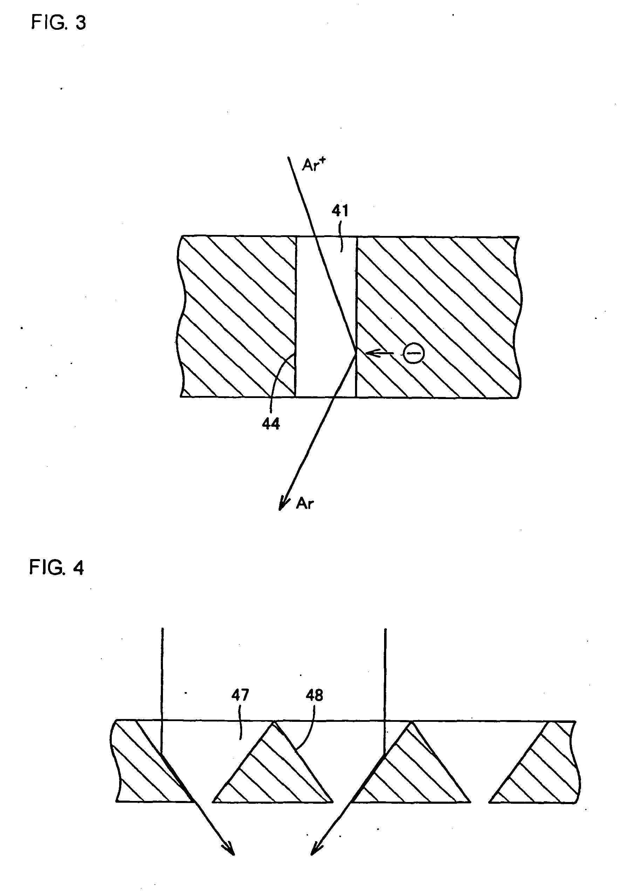

Fig. 3 shows a state in which positively charged argon Ar⁺ gas passes through a distribution plate 16. Here, the deposition gas passage 40 is omitted. Referring to Fig 3, when the argon Ar⁺ gas passes through the hole, it impinges on a wall surface 44 of the hole 41. At this time, in a case where a negative bias voltage is being applied to the distribution plate 16, the argon Ar⁺ gas is neutralized and it is supplied to the deposition chamber 20 as the neutralized argon Ar gas. Thus, the argon Ar gas can be supplied to the deposition chamber, keeping its kinetic energy. As a result, a processing rate can be increased. In addition, this neutralization is not limited to the inert gas and the same is applied to the radical such as hydrogen, oxygen, nitrogen and the like generated in the plasma generation chamber. However, Fig 3 does not show an embodiment of the present invention.

Fig. 4 is a view showing one variation of the distribution plate in Fig. 3 in accordance with the present invention. Referring to Fig. 4, as required by the present invention a diameter of a hole 47 provided in a distribution plate 16 is large on an upper surface and small on a lower surface. Therefore, when an ionized inert gas and the like from the plasma generation chamber 14 passes through the hole 47, it has a high probability of impinging on a wall surface 48, so that more neutralized inert gas or radicals can be provided.

In addition, in order to increase the probability of impinging of the inert gas and the like on the wall surface 48, a thickness of the distribution plate 16 may be increased.

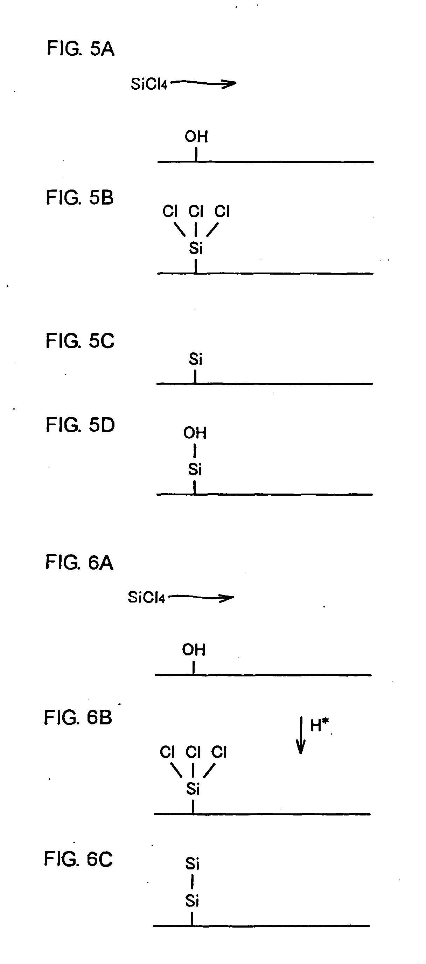

Next, a deposition method useable in conjunction with this embodiment will be described, comparing with the conventional deposition method in the Japanese Unexamined Patent Publication No. 2002-539326. Figs. 5A to 5D show the conventional deposition method according to the Japanese Unexamined Patent Publication No. 2002-539326 and Figs. 6A to 6C show the deposition method according to this embodiment step by step.

First, the conventional method will be described with reference to Figs. 5A to 5D. Here, the description will be made of an example in which silicon tetrachloride SiCl4 is used as the deposition gas. According to the conventional method, silicon tetrachloride SiCl4 is supplied in a condition a substrate surface is terminated with hydroxyl (-OH) (Fig. 5A).

Then, O-SiCl₃ is adhered to the substrate and HCl is detached. Since the deposition gas is continuously supplied, the substrate surface is gradually covered with Cl atoms (Fig. 5B), and the substrate surface is saturated with the Cl atoms. Thus, in order to remove the superfluous deposition gas, the surface is purged with an inert gas (Fig. 5C). Then, the original surface saturated with hydroxyl is formed using a hydrogen radical and an oxygen radical (Fig. 5D).

Next, the deposition method usable in conjunction with an embodiment of the present invention will be described. Figs. 6A to 6C show the deposition method step by step. Referring to Figs. 6A to 6C, silicon tetrachloride SiCl4 is supplied as the deposition gas in a condition that a substrate surface is terminated with hydroxyl (-OH) (Fig. 6A), so that O-SiCl₃ is adhered to the substrate and HCl is detached, which is the same as the conventional method.

However, even when the deposition gas is continuously supplied, since H radicals of hydrogen gas are continuously supplied (Fig. 6B) at the same time, Cl atom reacts with the hydrogen radical H, so that the substrate is not covered with Cl and a layer having desired atoms is continuously formed (Fig. 6C).

As described above, according to the deposition method of this embodiment, since the purging process shown in Fig. 5C is not needed, a processing ability for depositing a metal film on the semiconductor substrate can be enhanced.

In addition, since the radical which assists the reaction is continuously supplied, a non-reacted deposition gas can be reduced. Therefore, the non-reacted deposition gas is not contained in the film as is done conventionally. As a result, a high-quality film can be formed.

In addition, the deposition gas is not necessarily supplied continuously to the substrate but it may be supplied intermittently.

In this case, it is preferable to form the film by neutralizing the radical with application of the bias voltage at the time of processing, since the treatment can be performed with higher energy as described above.

According to a specific example of the deposition condition, a flow rate of argon gas as the treatment gas is 100sccm and a flow rate of the deposition gas is 0.1 to 100sccm.

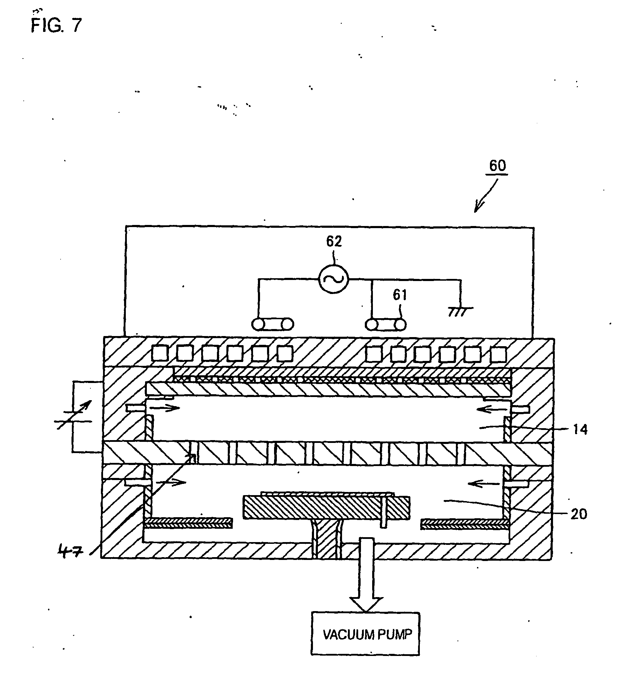

Next, an exemplary apparatus not being an embodiment of the present invention will be described. Fig. 7 is a schematic sectional view showing a deposition apparatus not being an embodiment of the present invention. Referring to Fig. 7, the deposition apparatus does not use the microwave to generate plasma like in the above embodiment, but it uses a plasma generation apparatus which generates inductively coupled plasma. That is, this type of plasma deposition apparatus 60 comprises a coil 61 and an AC power supply 62 which applies high frequency to the coil 61, in order to generate plasma in a plasma generation chamber 14. Since other components are the same as those in the above embodiment, their descriptions will not be reiterated.

Although the case where a metal film is formed of silicon on the substrate has been described in the above embodiment, the present invention is not limited to this. Various kinds of oxide films, nitride films and metal films can be formed when the treatment gas and the deposition gas are appropriately selected. That is, when the oxide film, the nitride film, and the metal film are formed, oxygen gas, nitrogen gas, and hydrogen gas are supplied to the plasma generation chamber 14 as the treatment gas, respectively.

In addition, although the case where the hydrogen radical is used as a radical has been described in the above embodiment, the present invention is not limited to this. As described above, another radical such as oxygen or nitrogen may be used depending on the treatment.

Furthermore, although the case where the passage to supply the deposition gas is incorporated in the distribution plate has been described in the above embodiment, the present invention is not limited to this and the distribution plate and the passage to supply the deposition gas may be separately provided.

Although the embodiments of the present invention have been described with reference to the drawings in the above, the present invention is not limited to the above illustrated embodiments. Various kinds of modifications and variations may be added to the illustrated embodiments within the scope of the appended claims.

### INDUSTRIAL APPLICABILITY

In embodiments of the deposition apparatus and the deposition method of the present invention, since the film will not be formed in the plasma generation chamber, the substrate is not saturated with the deposition gas as in the conventional case, and the purging process is not needed, the deposition time can be reduced. As a result, this deposition apparatus and deposition method are advantageously used in the deposition treatment.

## Claims

1. A deposition apparatus (10) for processing a substrate (W) comprising:
a treatment container (15) in which said substrate (W) is processed;
a dielectric plate (31) placed at the opening of said treatment container (15) through a sealing member;
deposition gas supplying means (17) arranged to supply deposition gas in said treatment container (15);
a distribution plate (16) having a plurality of through holes (47) separating a plasma generation chamber (14) and a deposition chamber (20) in the treatment container (15);
a coaxial waveguide (29) and an antenna (33) located above said dielectric plate (31) for generating plasma of said gas in said plasma generation chamber (14);
a pedestal (35) located in said treatment container (15) to hold said substrate;
evacuating means (26) for evacuating said treatment container (15) ; wherein said coaxial waveguide (29) has an antenna (33) on the dielectric plate (31)
said antenna (33) is a planar antenna having slots and microwaves are provided from said antenna to produce said plasma; **characterised in that**:
said through holes (47) of said distribution plate (16) are formed in a manner that a pressure in the plasma generation chamber (14) becomes positive as compared with the pressure in the deposition chamber (20); and
a diameter of said through holes (47) in the distribution plate (16) is large on an upper surface and small on a lower surface.

2. The deposition apparatus according to claim 1, wherein said distribution plate (16) is formed of carbon, silicon or aluminium.

3. The deposition apparatus according to any one of claims 1 or 2, wherein said gas supplying means (17, 18) has a first gas supplying nozzle (17) provided in said plasma generating chamber (14) and a second gas supplying nozzle (18) provided in said deposition chamber (20) for supplying a second processing gas to said deposition chamber (20).

4. The deposition apparatus according to any one of claims 1 to 3, wherein said distribution plate (16) has gas passages (42) and said deposition gas is distributed through said gas passages (42) into said deposition chamber (20).

5. The deposition apparatus according to any one of claims 1 to 4, wherein said dielectric plate is formed of either one of AlN, Al₂O₃ and SiO₂.

6. The deposition apparatus according to any one of claims 1 to 5, comprising means for applying a predetermined bias voltage between said plasma generation chamber and said substrate processing chamber.

## Patentansprüche

1. Ablagerungsvorrichtung (10) zur Bearbeitung eines Substrates (W) umfassend:
ein Behandlungsbehältnis (15) in dem das Substrat (W) bearbeitet wird;
eine dielektrische Platte (31), die durch ein Versiegelungselement an die Öffnung des Behandlungsbehältnises (15) angebracht ist;
eine Ablagerungsgasbereitstellungseinrichtung (17), die dafür eingerichtet ist, im Behandlungsbehältnis (15) Ablagerungsgas bereitzustellen;
eine Verteilerplatte (16) mit einer Mehrzahl an Durchgangsöffnungen (47), die eine Plasmaerzeugungskammer (14) und eine Ablagerungskammer (20) in dem Behandlungsbehältnis (15) trennt;
ein koaxialer Wellenleiter (29) und eine Antenne (33), die sich oberhalb der dielektrischen Platte (31) befindet, zum Erzeugen von Plasma des Gases in der Plasmaerzeugungskammer (14);
ein sich im Behandlungsbehältnis (15) befindender Sockel (35) zur Aufnahme des Substrats;
eine Evakuierungseinrichtung (26) zur Evakuierung des Behandlungsbehältnises (15); wobei der koaxiale Wellenleiter (29) eine Antenne (33) auf der dielektrischen Platte (31) aufweist;
wobei die Antenne (33) eine planare Antenne ist, die Aussparungen aufweist und Mikrowellen von der Antenne zum Herstellen des Plasmas bereitgestellt werden; **dadurch gekennzeichnet, dass**
die Durchgangsöffnungen (47) der Verteilerplatte (16) auf eine Art ausgebildet sind, dass ein Druck in der Plasmaerzeugungskammer (14) im Vergleich mit dem Druck in der Ablagerungskammer (20) positiv wird; und
ein Durchmesser der Durchgangsöffnungen (47) in der Verteilerplatte (16) groß in einer oberen Oberfläche und klein in einer unteren Oberfläche ist.

2. Ablagerungsvorrichtung nach Anspruch 1, wobei die Verteilerplatte (16) aus Karbon, Silicon oder Aluminium geformt ist.

3. Ablagerungsvorrichtung nach einem der Ansprüche 1 oder 2, wobei die Gasbereitstellungseinrichtung (17, 18) eine erste Gasbereitstellungsdüse (17), die in der Plasmaerzeugungskammer (14) vorgesehen ist, und eine zweite Gasbereitstellungsdüse (18), die in der Ablagerungskammer (20) vorgesehen ist, um der Ablagerungskammer (20) ein zweites Bearbeitungsgas bereitzustellen, aufweist.

4. Ablagerungsvorrichtung nach einem der Ansprüche 1 bis 3, wobei die Verteilerplatte (16) Gasdurchgänge (42) aufweist und das Ablagerungsgas durch die Gasdurchgänge (42) in die Ablagerungskammer (20) verteilt wird.

5. Ablagerungsvorrichtung nach einem der Ansprüche 1 bis 4, wobei die dielektrische Platte entweder aus AlN, Al₂O₃ oder SiO₂ gebildet ist.

6. Ablagerungsvorrichtung nach einem der Ansprüche 1 bis 5, umfassend eine Einrichtung zum Anlegen einer vorbestimmten Vorspannung zwischen der Plasmaerzeugungskammer und der Substratbearbeitungskammer.

## Revendications

1. Appareil de dépôt (10) destiné à traiter un substrat (W) comprenant :
un récipient de traitement (15) dans lequel ledit substrat (W) est traité ;
une plaque diélectrique (31) placée au niveau de l'ouverture dudit récipient de traitement (15) à travers un élément d'étanchéité ;
un moyen d'alimentation en gaz de dépôt (17) agencé pour alimenter un gaz de dépôt dans ledit récipient de traitement (15) ;
une plaque de distribution (16) ayant une pluralité de trous traversants (47) séparant une chambre de génération de plasma (14) et une chambre de dépôt (20) dans le récipient de traitement (15) ;
un guide d'ondes coaxial (29) et une antenne (33) située au-dessus de ladite plaque diélectrique (31) pour générer un plasma dudit gaz dans ladite chambre de génération de plasma (14) ;
un socle (35) situé dans ledit récipient de traitement (15) pour maintenir ledit substrat ;
un moyen d'évacuation (26) destiné à évacuer ledit récipient de traitement (15) ; où ledit guide d'ondes coaxial (29) a une antenne (33) sur la plaque diélectrique (31),
ladite antenne (33) est une antenne planaire ayant des fentes et des micro-ondes sont fournies à partir de ladite antenne afin de produire ledit plasma ; **caractérisé en ce que** :
lesdits trous traversants (47) de ladite plaque de distribution (16) sont formés de manière à ce qu'une pression dans la chambre de génération de plasma (14) devienne positive par rapport à la pression dans la chambre de dépôt (20) ; et
un diamètre desdits trous traversants (47) dans la plaque de distribution (16) est grand sur une surface supérieure et petit sur une surface inférieure.

2. Appareil de dépôt selon la revendication 1, dans lequel ladite plaque de distribution (16) est formée de carbone, de silicium ou d'aluminium.

3. Appareil de dépôt selon l'une quelconque de la revendication 1 ou 2, dans lequel ledit moyen d'alimentation en gaz (17, 18) a une première buse d'alimentation en gaz (17) prévue dans ladite chambre de génération de plasma (14) et une deuxième buse d'alimentation en gaz (18) prévue dans ladite chambre de dépôt (20) pour alimenter un deuxième gaz de traitement à ladite chambre de dépôt (20).

4. Appareil de dépôt selon l'une quelconque des revendications 1 à 3, dans lequel ladite plaque de distribution (16) comporte des passages de gaz (42) et ledit gaz de dépôt est distribué à travers lesdits passages de gaz (42) dans ladite chambre de dépôt (20).

5. Appareil de dépôt selon l'une quelconque des revendications 1 à 4, dans lequel ladite plaque diélectrique est formée de l'un de l'AlN, de l'Al₂O₃ et de SiO₂.

6. Appareil de dépôt selon l'une quelconque des revendications 1 à 5, comprenant un moyen destiné à appliquer une tension de polarisation prédéterminée entre ladite chambre de génération de plasma et ladite chambre de traitement de substrat.
